# EUROPEAN PATENT APPLICATION

(11) **EP 1 754 800 A1**
(43) Date of publication of application: **21.02.2007**
(21) Application number: 05736639.5
(22) Date of filing: 28.04.2005
(51) Int. Cl.: C23C 16/40, H01L 21/316

(54) **MATERIAL FOR CHEMICAL VAPOR DEPOSITION AND THIN FILM FORMING METHOD**

(30) Priority: 26.05.2004 JP 2004155543
(71) Applicant: Adeka Corporation, Tokyo 116-8554 (JP)
(72) Inventor: Hosokawa, Masaru, Arakawa-ku,Tokyo 116-8554 (JP); Matsushita, Masakatsu, Arakawa-ku,Tokyo 116-8554 (JP); Nakagawa, Satoshi, Arakawa-ku,Tokyo 116-8554 (JP)
(74) Representative: Forstmeyer, Dietmar
(86) International application number: PCT/JP2005/008145
(87) International publication number: WO 2005/116292

(57) **Abstract**

A material for chemical vapor deposition of the present invention contains a precursor composed of a metal compound, and has 100 or less particles having a size of 0.5 µm or more in 1 ml, in particle measurement by a light scattering type submerged particle detector in a liquid phase. A thin film can be prevented from being contaminated by particles even when a highly degradable metal compound is used as the precursor.

## Description

### Technical Field:

The present invention relates to a material for chemical vapor deposition comprising a precursor composed of a metal compound having reduced number of particles in a liquid phase of the material and a thin film forming method using the same.

### Background Art:

A thin film consisting of metal atoms or a thin film comprising metal atoms is used as a member of an electronic component, such as electrodes, high dielectric constant capacitors, ferroelectric capacitors, gated insulators, and barrier films, and as a member of an optical communication element, such as optical waveguides, light amplifiers, and optical switches.

As a method for forming the above-described thin film, chemical vapor deposition (hereinafter, sometimes abbreviated as CVD) process including ALD (Atomic Layer Deposition) is the most suitable formation process owing to a number of advantages, such as compositional controllability, excellent step coverage, suitability to large volume production, and capability of hybrid integration. Further, when a material that can be delivered or fed in a liquid phase in the steps of a CVD process is used as the material in the CVD process, process control and maintenance are easily performed.

In CVD processes using precursors comprising metal compounds that are highly susceptible to decomposition or hydrolysis, such as metal alkoxides, metal amides, β-diketonate metal complexes, and alkyl metals, contamination of the resultant thin films by particles is problematic, and methods for reducing this contamination are reported in, for example, Patent Documents 1 to 4. Patent Document 1 describes a method of connecting a purge gas line and a reactor through a purge gas introducing mechanism, in a liquid-phase CVD process using (trimethylvinylsilyl)hexafluoroacetylacetonatocupper or tetrakis(dimethyamino)titanium. Patent Document 2 describes a method of using a complex alkoxide prepared by mixing precursors in forming a thin film of tantalum-titanium complex oxide. Patent Document 3 describes a method of using a mixture of silicon alkoxide with hafnium alkoxide or zirconium alkoxide in forming silicon-hafnium complex oxide or silicon-zirconium complex oxide. Patent Document 4 describes a method of reducing chlorine impurity in tantalum alkoxide in forming tantalum oxide.

The method described in Patent Document 1 suppresses generation of particles through invention of a CVD apparatus, each of the methods described in Patent Documents 2 and 3 reduces particles originating from chemical reaction with the use of complex source materials, and the method described in Patent Document 4 reduces particles resulting from impurities by reducing the impurity component in the source materials. Any of these is a method of reducing particles that are generated in CVD processes.

As methods for suppressing contamination by particles, a method of reducing particles in reagents used is effective. For organic solvents used as line washing or precursor solvents and precursor compounds with low decomposability such as tetraethyl silicate (TEOS), reagents with reduced particles have been supplied. For materials for CVD using a highly decomposable metal compound as a precursor, however, any material with reduced particles has not yet been available because the precursor itself generates particles with an action of a trace amount of water contained in device members, such as a storage container and a filling apparatus, carrier gasses, solvents, or the like.

Patent Document 1: Japanese Patent Laid-open Publication No. H9-302471
Patent Document 2: Japanese Patent Laid-open Publication No. 2002-53504
Patent Document 3: Japanese Patent Laid-open Publication No. 2002-53960
Patent Document 4: Japanese Patent Laid-open Publication No. H9-121027

### Disclosure of the Invention:

### Problems to be Solved by the Invention:

An object of the present invention is to provide a material for CVD using a highly decomposable metal compound as a precursor, the material that is capable of reducing contamination of thin films by particles.

### Means for Solving the Problems:

The present inventors, as a result of extensive investigations, have found that contamination of thin films by particles can be reduced by reducing particles in materials for CVD comprising a highly decomposable metal compound as a precursor. Based on this finding, the present inventors have pursued further investigation and found that, with a material for CVD wherein the number of particles having a specific size is reduced to be no more than a specific numerical value, contamination by particles is effectively suppressed, accomplishing the above objective.

The present invention, which is based on the above-described findings, provides a material for chemical vapor deposition (CVD) comprising a precursor composed of a metal compound, and has 100 or less particles having a size of 0.5 µm or more in 1 ml, in particle measurement by a light-scattering type submerged particle detector in a liquid phase; and a method for forming metal-containing thin films through a chemical vapor deposition process using the material for CVD.

### Brief Description of the Drawings:

[Fig. 1] Fig. 1 is a schematic diagram illustrating an example of a production apparatus used for producing the material for CVD of the present invention.
[Fig. 2] Fig. 2 is a schematic diagram illustrating an example of a light scattering type submerged particle system used for particle counting of the material for CVD of the present invention.
[Fig. 3] Fig. 3 is a schematic diagram illustrating an example of a CVD instrument used in the method for forming metal-containing thin films of the present invention.

### Best Mode for Carrying Out the Invention:

There is no particular limitation on the metal atom composing the metal compound that serves as the precursor relating to the present invention. Any metal atoms may be arbitrarily selected so as to compose a thin film of metal, alloy, metal oxide, complex metal oxide, metal nitride, complex metal nitride, metal carbide, complex metal carbide, a mixture of two or more kinds thereof, or the like with a desired composition.

As the above-described metal atom, there may be mentioned the group-1 elements such as lithium, sodium, potassium, rubidium, and cesium; the group-2 elements such as beryllium, magnesium, calcium, strontium, and barium; the group-3 elements such as scandium, yttrium, lanthanides (lanthanum, cerium, praseodymium, neodymium, promethium, samarium, europium, gadolinium, terbium, dysprosium, holmium, erbium, thulium, ytterbium, lutetium), and actinides; the group-4 elements including titanium, zirconium, and hafnium; the group-5 elements including vanadium, niobium, and tantalum; the group-6 elements such as chromium, molybdenum, and tungsten; the group-7 elements including manganese, technetium, and rhenium; the group-8 elements including iron, ruthenium, and osmium; the group-9 elements including cobalt, rhodium, and iridium; the group-10 elements including nickel, palladium, and platinum; the group-11 elements including copper, silver, and gold; the group-12 elements including zinc, cadmium, and mercury; the group-13 elements including aluminum, gallium, indium, and thallium; the group-14 elements including germanium, tin, and lead; the group-15 elements including arsenic, antimony, and bismuth; and the group-16 element including polonium.

The ligand that bonds to the above-described metal atom and composes a metal compound includes halides such as chloride, bromide, and iodide; alkanes; monoalkylamines; dialkylamines; silylamines such as trimethylsilylamine and triethylsilylamine; alkanimines such as methanimine, ethanimine, propanimine, 2-propanimine, butanimine, 2-butanimine, isobutanimine, tert-butanimine, pentanimine, and tert-pentanimine; cyclopentadienes; alcohols such as monools and diols; β-diketones such as acetylacetone, hexane-2,4-dione, 5-methylhexane-2,4-dione, heptane-2,4-dione, 2-methylheptane-3,5-dione, 5-methylheptane-2,4-dione, 6-methylheptane-2,4-dione, 2,2-dimethylheptane-3,5-dione, 2,6-dimethylheptane-3,5-dione, 2,2,6-trimethylheptane-3,5-dione, 2,2,6,6-tetramethylheptane-3,5-dione, octane-2,4-dione, 2,2,6-trimethyloctane-3,5-dione, 2,6-dimethyloctane-3,5-dione, 2,9-dimethylnonane-4,6-dione, 2-methyl-6-ethyldecane-3,5-dione, 2,2-dimethyl-6-ethyldecane-3,5-dione, 1,1,1-trifluoropentane-2,4-dione, 1,1,1-trifluoro-5,5-dimethylhexane-2,4-dione, 1,1,1,5,5,5-hexafluoropentane-2,4-dione, 1,3-diperfluorohexylpropane-1,3-dione, 1,1,5,5-tetramethyl-1-methoxyhexane-2,4-dione, 2,2,6,6-tetramethyl-1-methoxyheptane-3,5-dione and 2,2,6,6-tetramethyl-1-(2-methoxyethoxy)heptane-3,5-dione; β-ketoesters such as methyl acetoacetate, ethyl acetoacetate, butyl acetoacetate, and 2-methoxyethyl acetoacetate; and the like. Among these, one kind of ligand may bond to the metal atom, or two or more kinds of them may bond to the metal.

Among the above-described metal compounds, as compounds that significantly suffer from the problem of particle contamination owing to their high susceptibility to decomposition or hydrolysis, there may be mentioned metal alkoxides, metal amides, alkyl metals, and cyclopentadienyl complexes containing, as ligands, alcohols, organic amines, or hydrocarbons that derive groups represented by general formula (I) or (II) shown below. Even when these metal compounds are used as precursors, the material for CVD of the present invention can prevent the particle contamination from occurring. Among precursors using these ligands, particularly valuable metal compounds include aluminum compounds, titanium compounds, zirconium compounds, hafnium compounds, tantalum compounds, and niobium compounds.

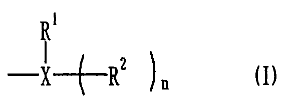

In the formula, X represents an oxygen atom or a nitrogen atom; n represents 0 when X is an oxygen atom or 1 when X is a nitrogen atom; R¹ represents an organic group having 1 to 10 carbon atoms; and R² represents a hydrogen atom or an organic group having 1 to 10 carbon atoms.

-R³ (II)

In the formula, R³ represents an alkyl group having 1 to 8 carbon atoms or a cyclopentadienyl group having 1 to 10 carbon atoms.

As the organic group having 1 to 10 carbon atoms represented by R¹ or R² in general formula (I), there may be mentioned, for example, hydrocarbon groups such as methyl, ethyl, propyl, isopropyl, butyl, sec-butyl, tert-butyl, isobutyl, amyl, isoamyl sec-amyl, tert-amyl, hexyl, 3-methylpentan-3-yl, heptyl, 3-heptyl, isoheptyl, tert-heptyl, n-octyl, isooctyl, tert-octyl, 2-ethylhexyl, nonyl, decyl, cyclopentyl, cyclohexyl, methylcyclohexyl, phenyl, methylphenyl, ethylphenyl, and benzyl; etheral alkyl groups such as 2-methoxyethyl, 2-ethoxyethyl, 2-butoxyethyl, 2-(2-methoxyethoxy)ethyl, 3-methoxypropyl, 2-methoxy-1-methylethyl, 2-methoxy-1,1-dimethylethyl, 2-ethoxy-1-methylethyl, 2-ethoxy-1,1-dimethylethyl, 2-isopropoxy-1,1-dimethylethyl, 2-butoxy-1,1-dimethylethyl, and 2-(2-methoxyethoxy)-1,1-dimethylethyl; fluoroalkyl groups such as trifluoromethyl, 1,1,1-trifluoroethyl, and pentafluoroethyl; aminoalkyl groups such as 2-(dimethylamino)ethyl, 2-(diethylamino)ethyl, 2-(ethylmethyl)aminoethyl, 3-(dimethylamino)propyl, 2-(dimethylamino)-1-methylethyl, 2-(diethylamino)-1-methylethyl, 2-(dimethylamino)-1,1-dimethylethyl, 2-(diethylamino)-1,1-dimethylethyl, and 2-(ethylmethylamino)-1,1-dimethylethyl.

The metal compound containing a group represented by general formula (I) is a compound wherein at least one group represented by general formula (I) bonds to the metal atom, and the metal compound is generally used, wherein all the possible coordination sites are coordinated. The metal compound may be any of a monomeric metal alkoxide, a monomeric metal amide, and a complex metal compound such as a double alkoxide. Here, the metal compound is not limited to any specific positional isomer or optical isomer. Furthermore, when the terminus of R¹ or R² is an electron-donating group such as a dialkylamino group and an alkoxy group, the electron-donating group may coordinate to the metal atom. In the present specification, for convenience, such an electron-donating group is represented as a form not coordinated to a metal.

In general formula (II) relating to the present invention, the alkyl group having 1 to 8 carbon atoms represented by R³ includes methyl, ethyl, propyl, isopropyl, butyl, sec-butyl, tert-butyl, isobutyl, amyl, isoamyl, sec-amyl, tert-amyl, hexyl, heptyl, 3-heptyl, isoheptyl, tert-heptyl, n-octyl, isooctyl, tert-octyl, 2-ethylhexyl and the like; and the cyclopentadienyl group having 1 to 10 carbon atoms includes cyclopentadienyl, methylcyclopentadienyl, ethylcyclopentadienyl, propylcyclopentadienyl, isopropylcyclopentadienyl, butylcyclopentadienyl, tert-butylcyclopentadienyl, dimethylcyclopentadienyl, pentamethylcyclopentadienyl and the like.

The aluminum compound usable as the precursor relating to the present invention includes, for example, compounds represented by general formula (III) or (IV).

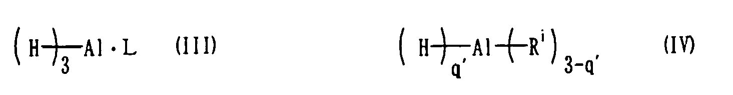

In the formulae, L represents a 5- to 6-membered coordinating heterocyclic compound having a nitrogen atom or an oxygen atom; R¹ represents an alkyl group having 1 to 4 carbon atoms; and q' represents an integer of 0 to 2.

In general formula (III), the coordinating heterocyclic compound represented by L includes crown ethers such as 18-crown-6, dicyclohexyl-18-crown-6, 24-crown-8, dicyclohexyl-24-crown-8, dibenzo-24-crown-8 and the like; cyclic polyamines such as cyclam, and cyclene; pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole, oxathiolane and the like. In general formula (IV), the alkyl group having 1 to 4 carbon atoms represented by Rⁱ includes methyl, ethyl, propyl, isopropyl, butyl, sec-butyl, tert-butyl, isobutyl and the like. Specific examples of the compounds represented by general formula (III) or (IV) include trimethylaluminum, N-methylpyrrolidinylalane and the like.

The titanium compounds, zirconium compounds, and hafnium compounds usable as the precursors relating to the present invention include, for example, compounds represented by general formula (V) or (VI).

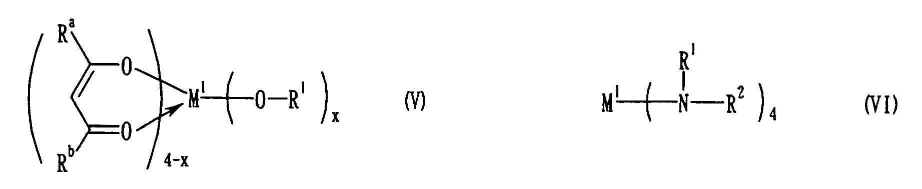

In the formulae, each of R^{a} and R^{b} represents an organic group having 1 to 10 carbon atoms; M¹ represents titanium, zirconium, or hafnium; R¹ and R² represent groups similar to those in general formula (I); and x represents 1, 2, 3, or 4.

In general formula (V), the organic group having 1 to 10 carbon atoms represented by R^{a} or R^{b} includes groups exemplified by R¹ in general formula (I). The specific example of the compound represented by general formula (V) includes compounds Nos. 1 to 39 shown below.

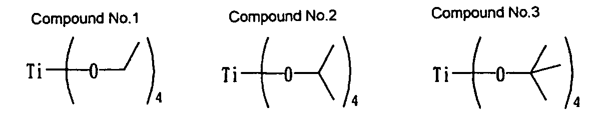

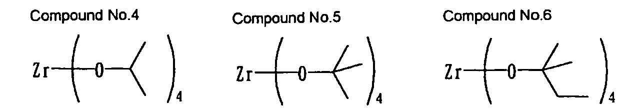

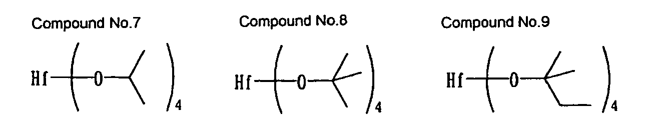

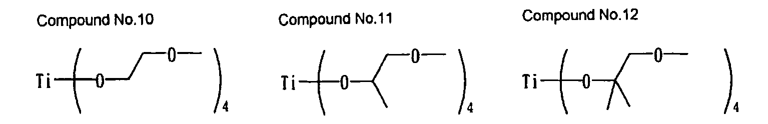

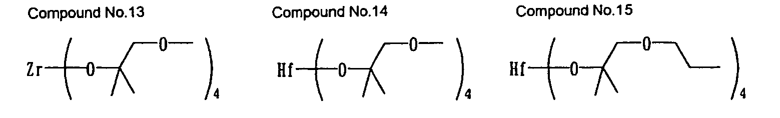

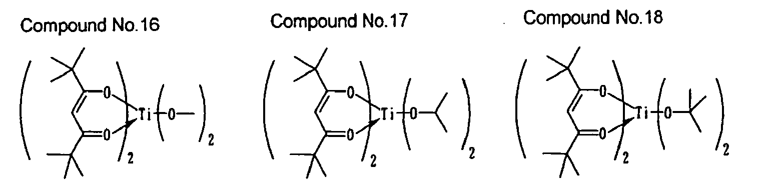

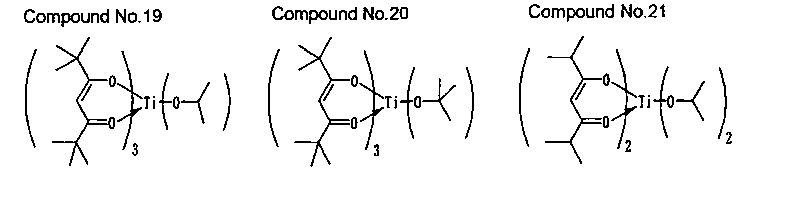

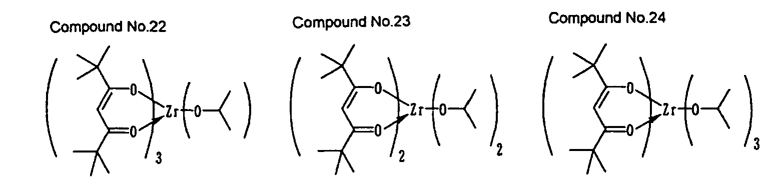

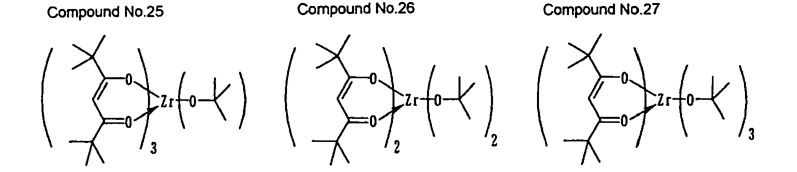

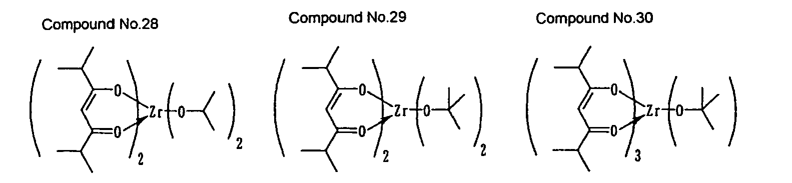

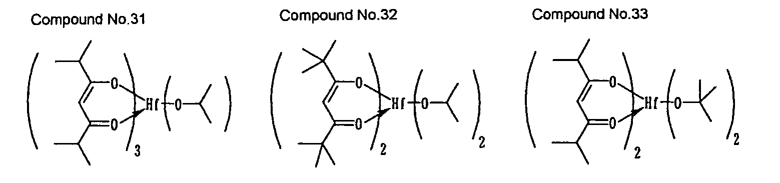

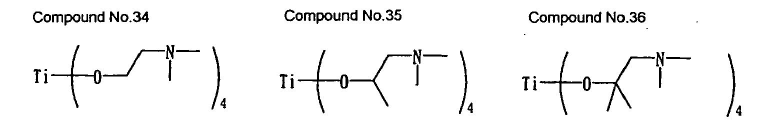

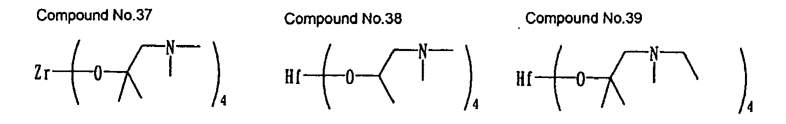

The specific example of the compound represented by general formula (VI) includes compounds Nos. 40 to 51 shown below.

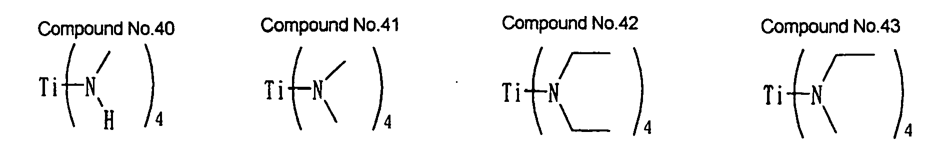

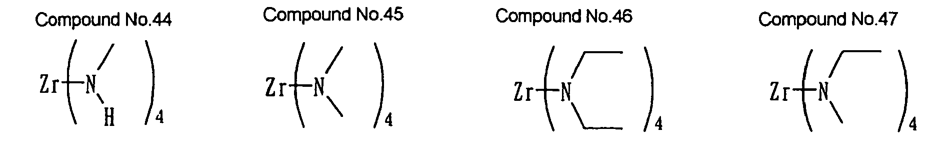

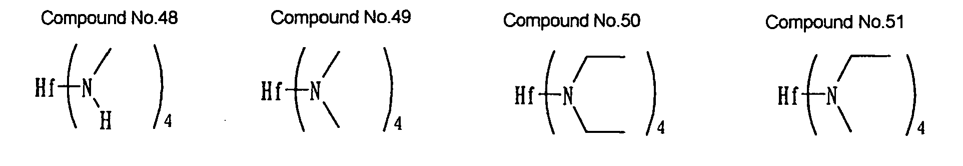

The tantalum compounds and niobium compounds usable as the precursor relating to the present invention include, for example, the compounds represented by general formula (VII) or (VIII).

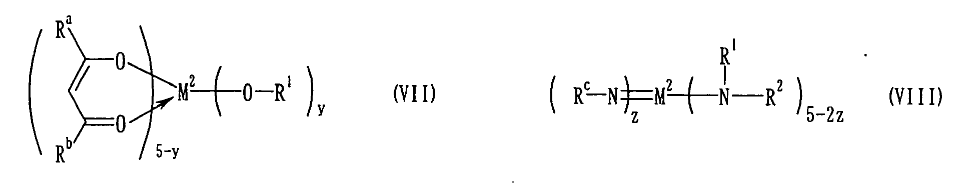

In the formulae, each of R^{a} and R^{b} represents an organic group having 1 to 10 carbon atoms; R^{c} represents an alkyl group having 1 to 5 carbon atoms; M² represents niobium or tantalum; R¹ and R² represent groups similar to those in general formula (I); y represents 1, 2, 3, 4, or 5; and z represents 0, 1, or 2.

In general formulae (VII) and (VIII), the organic group having 1 to 10 carbon atoms represented by R^{a} or R^{b} includes groups exemplified by R¹ in general formula (I), while the alkyl group having 1 to 5 carbon atoms represented by R^{c} includes methyl, ethyl, propyl, isopropyl, butyl, sec-butyl, tert-butyl, isobutyl, amyl, isoamyl, sec-amyl, and tert-amyl. The specific example of the compound represented by general formula (VII) includes compounds Nos. 52 to 74 shown below.

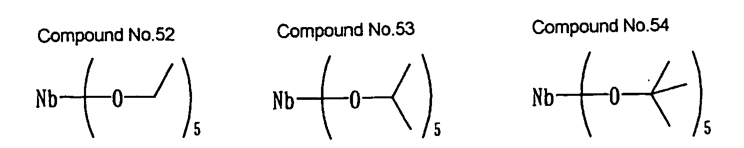

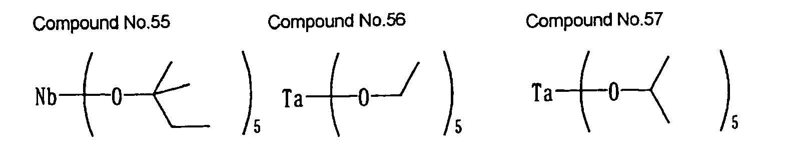

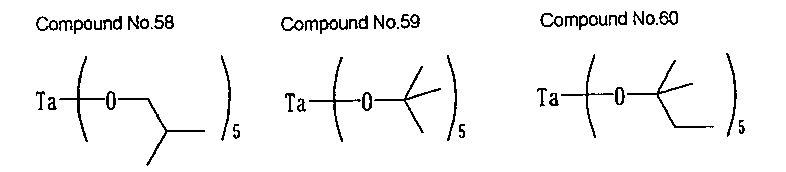

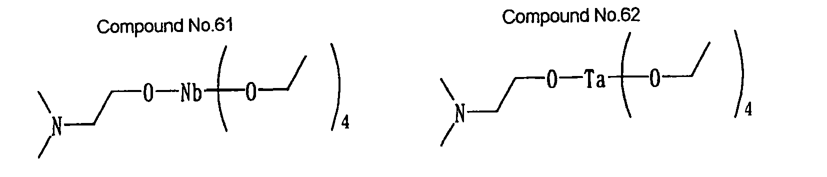

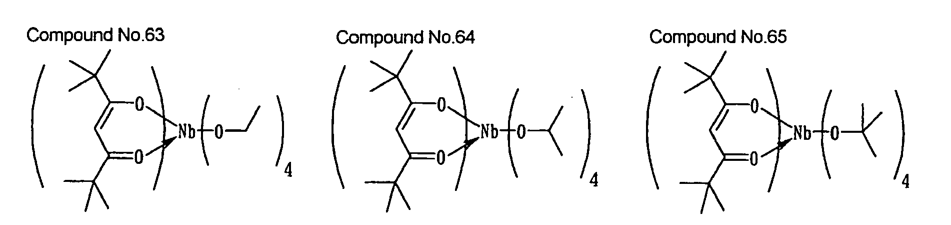

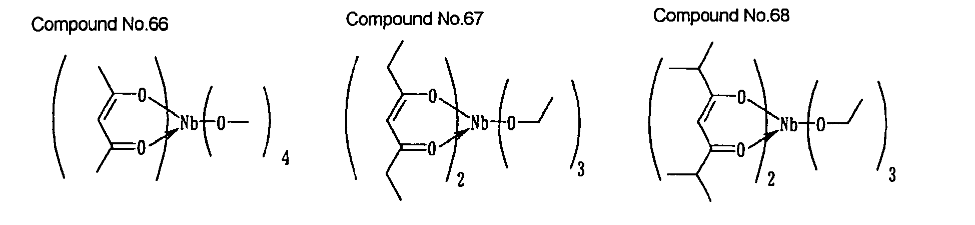

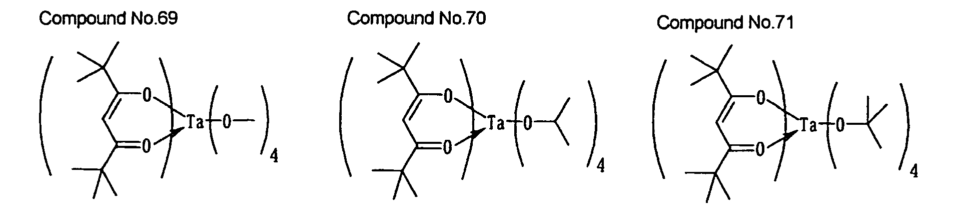

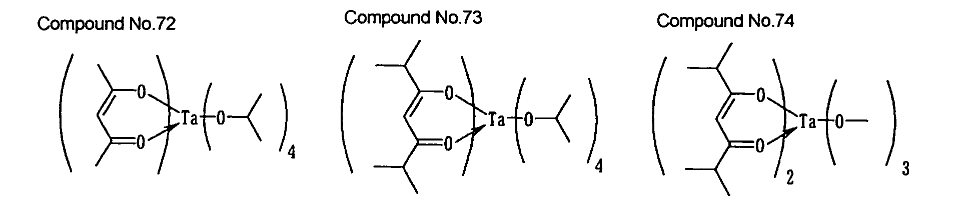

The specific example of the compound represented by general formula (VIII) includes compounds Nos. 75 to 92 shown below.

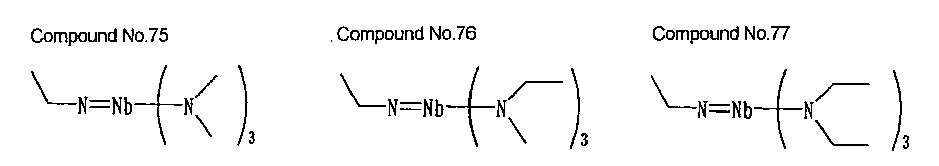

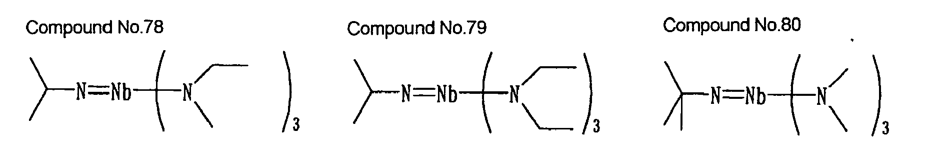

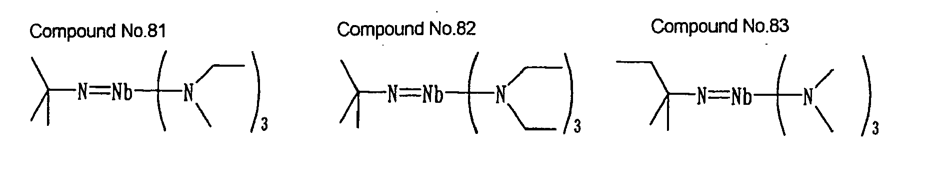

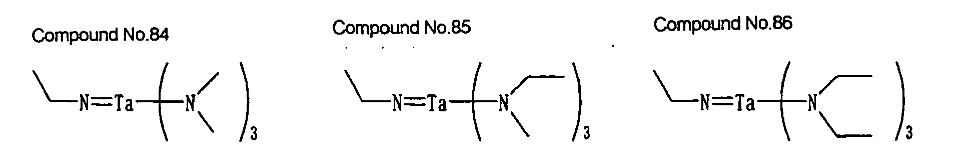

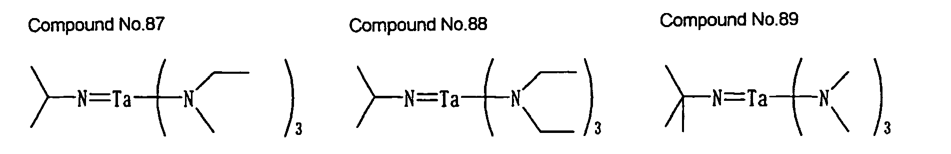

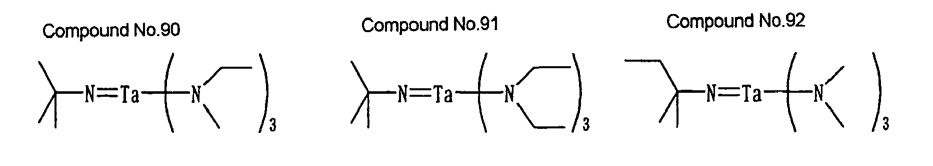

The double alkoxide-type precursor usable as the precursor relating to the present invention includes, for example, compounds represented by general formula (IX).

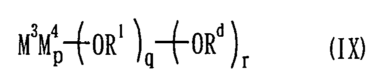

In the formula, R^{d} represents an organic group having 1 to 10 carbon atoms; R¹ represents a group similar to that in general formula (I); at least one of M³ and M⁴ represents titanium, zirconium, hafnium, niobium, or tantalum; the other represents a metal atom; p represents 1 or 2; (q + r) represents the sum of the valencies of metal atom M³ and metal atom M⁴ contained in the molecule.

In general formula (IX), the organic group having 1 to 10 carbon atoms represented by R^{d} includes the group exemplified by R¹, while the metal atom represented by M³ or M⁴ includes the metals exemplified in paragraph [0013]. The specific example of the compound represented by general formula (IX) includes compounds Nos. 93 to 115 shown below.

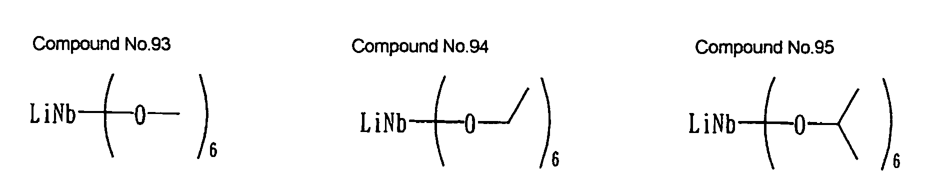

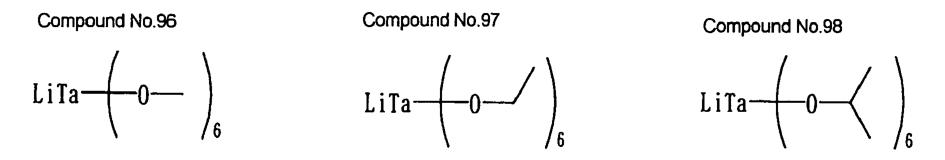

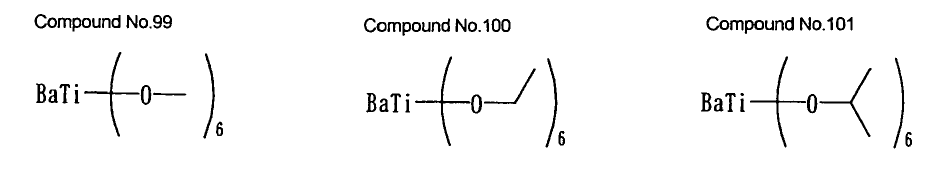

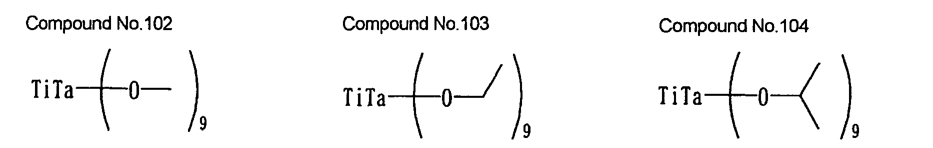

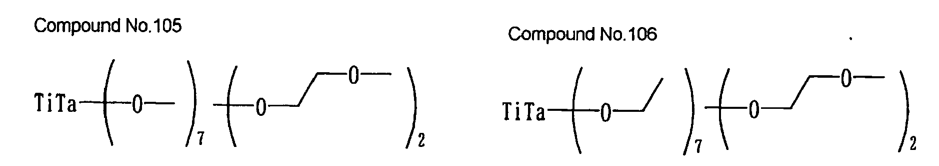

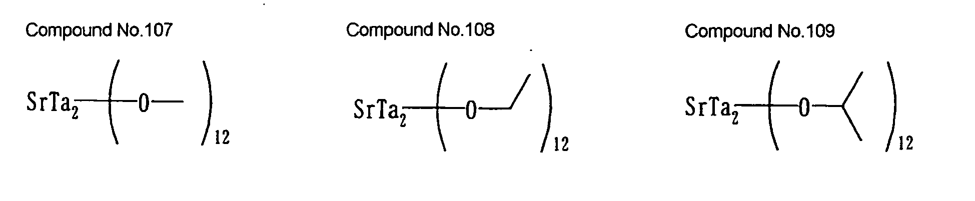

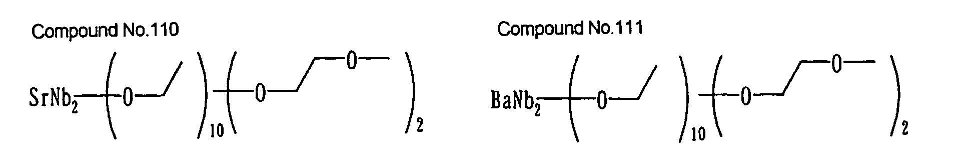

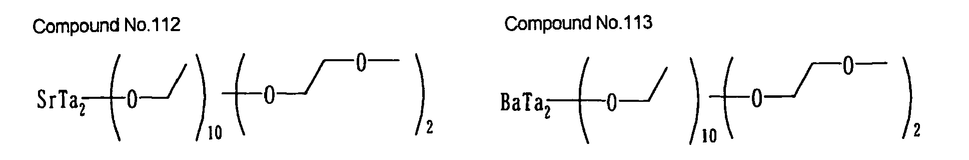

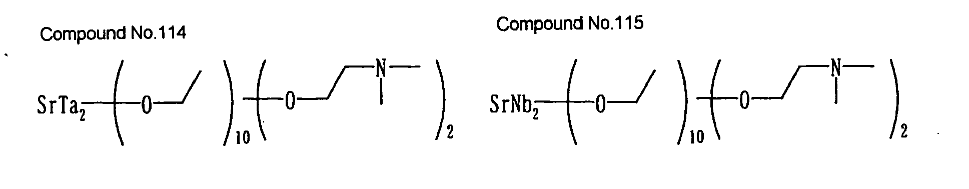

The material for chemical vapor deposition (CVD) of the present invention comprises the above-described metal compound as the precursor of thin film, and has 100 or less particles having a size of 0.5 µm or more in 1 ml liquid, in particle measurement by a light scattering type submerged particle detector in a liquid phase.

The form of the material for CVD of the present invention is selected appropriately according to the procedures of the CVD process adopted, such as a source delivery system. The source delivery system includes a vapor delivery system in which the material for CVD is vaporized by heating and/or pressure reduction in a container and introduced into a deposition reaction site, if needed, together with a carrier gas, such as argon, nitrogen, and helium; and a liquid delivery system in which the material for CVD is delivered in the form of a liquid or a solution to a vaporizer, where it is vaporized by heating and/or pressure reduction, and then introduced into a deposition reaction site. In the case of the vapor delivery system, the precursor metal compound itself serves as the material for CVD. In the case of the liquid delivery system, the material for CVD is the precursor metal compound itself or a solution of the precursor in an organic solvent.

In a multi-component CVD process, the source delivery system includes a system in which the individual components of the material for CVD are separately vaporized and delivered (hereinafter, sometimes referred to as a multi-source system) and a system in which a plurality of components of the material are mixed in advance at a desired ratio and the mixture is vaporized and delivered (hereinafter, sometimes referred to as a single source system). In the case of single source system, the source material for CVD is a mixture of metal compounds or a mixed solution wherein two or more kinds of metal compounds are dissolved in an organic solvent.

Accordingly, with respect to the material for CVD in the present invention, the state of liquid phase refers to the following two cases. One case concerns a metal compound itself or a mixture of metal compounds. In this case, the liquid state refers to a liquid state in a temperature region at which the material for CVD is delivered in a liquid form in the CVD process, and the temperature is usually 150°C or less. The other case refers to a solution state wherein one kind or two or more kinds of metal compounds are dissolved in an organic solvent. Usually, the solution delivery system using such a solution is adopted in the case of using a metal compound having a high melting point as the precursor or the case of using a mixture of metal compounds as the precursor.

The organic solvent used for the material for CVD in the solution delivery system is not particularly limited, and any widely known organic solvent can be used. The organic solvent includes, for example, alcohols such as methanol, ethanol, 2-propanol, and n-butanol; acetate esters such as ethyl acetate, butyl acetate, and methoxyethyl acetate; etheral alcohols such as ethylene glycol monomethyl ether, ethylene glycol monoethyl ether, ethylene glycol monobutyl ether, and diethylene glycol monomethyl ether; ethers such as tetrahydrofuran, tetrahydropyran, ethylene glycol dimethyl ether, diethylene glycol dimethyl ether, triethylene glycol dimethyl ether, dibutyl ether, and dioxane; ketones such as methyl butyl ketone, methyl isobutyl ketone, ethyl butyl ketone, dipropyl ketone, diisobutyl ketone, methyl amyl ketone, cyclohexanone, and methylcyclohexanone; hydrocarbons such as hexane, cyclohexane, methylcyclohexane, dimethylcyclohexane, ethylcyclohexane, heptane, octane, toluene, and xylene; hydrocarbons having cyano group(s) such as 1-cyanopropane, 1-cyanobutane, 1-cyanohexane, cyanocyclohexane, cyanobenzene, 1,3-dicyanopropane, 1,4-dicyanobutane, 1,6-dicyanohexane, 1,4-dicyanocyclohexane, and 1,4-dicyanobenzene; pyridine, and lutidine. These solvents may be used singly or as a mixed solvent of two or more kinds of them, depending on the solubility of the precursor solutes, temperature in use, boiling point, flash point, and the like. When such an organic solvent is used, the total concentration of the precursors in the organic solvent is preferably 0.01 to 2.0 mol/l, particularly 0.05 to 1.0 mol/l.

The material for CVD of the present invention may contain, if necessary, a nucleophilic agent to provide stability to the precursor. Such a nucleophilic agent includes ethylene glycol ethers such as glyme, diglyme, triglyme, and tetraglyme; crown ethers such as 18-crown-6, dicyclohexyl-18-crown-6, 24-crown-8, dicyclohexyl-24-crown-8, and dibenzo-24-crown-8; polyamines such as ethylenediamine, N,N,N',N'-tetramethylethylenediamine, diethylenetriamine, triethylenetetramine, tetraethylenepentamine, pentaethylenehexamine, 1,1,4,7,7-pentamethyldiethylenetriamine, 1,1,4,7,10,10-hexamethyltriethylenetetramine, triethoxytriethyleneamine, cyclic polyamines such as cyclam and cyclen; heterocyclic compounds such as pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole, and oxathiolane; β-ketoesters such as methyl acetoacetate, ethyl acetoacetate, and 2-methoxyethyl acetoacetate; and β-diketones such as acetylacetone, 2,4-hexanedione, 2,4-heptanedione, 3,5-heptanedione, and dipivaloylmethane. These nucleophilic agents as stabilizers are used in an amount of preferably 0.1 to 10 mol, more preferably 1 to 4 mol, with respect to 1 mol of the precursor.

The material for CVD of the present invention contains 100 or less particles having a size of 0.5 µm or more, preferably 100 or less particles having a size of 0.3 µm or more, further preferably 1000 or less particles and particularly preferably 100 or less particles having a size of 0.2 µm or more in 1 ml liquid, in particle measurement by a light scattering type submerged particle detector in a liquid phase.

The particle measurement in the liquid phase of the material for CVD of the present invention is based on the light scattering type submerged particle measurement method, and the measurement can be performed with a commercially available instrument with a laser as a light source. In the measurement, in order to sufficiently remove moisture contained in members that contact with the material for CVD, such as pipes and valves, in the measuring system, it is preferred to perform heated vacuum drying prior to use.

The method for producing the material for CVD of the present invention is not particularly limited, and the material can be produced according to conventional methods. For example, the material for CVD of the present invention can be obtained through a process in which sufficient purification and dehydration are performed for the source materials employed, such as metal compounds, organic solvents and nucleophilic agents, which are used as necessary, and inert gasses used for filling and purging; cleaned production and purification apparatuses are used; and further a filtration step with a filter of appropriate materials and standards is incorporated into the production process.

In purification of the metal compound, contents of impurity metal elements, halogens such as chlorine contaminant, and organic impurities in the metal compound are reduced as much as possible. The content of each impurity metal element is preferably 100 ppb or less, more preferably 10 ppb or less, and the total content of impurity metal elements is preferably 1 ppm or less, more preferably 100 ppb or less. The content of halogens such as chlorine contaminant is preferably 100 ppm or less, more preferably 10 ppm or less, furthermore preferably 1 ppm or less. The total content of organic impurities is preferably 500 ppm or less, more preferably 50 ppm or less, furthermore preferably 10 ppm or less. Because moisture causes generation of particles in the material for CVD and generation of particles during the CVD process, it is recommended to dehydrate the metal compounds, the organic solvents, and the nucleophilic agents as much as possible prior to use for reducing moisture contained in each of them. In each of the metal compound, the organic solvent and the nucleophilic agent, the moisture content is preferably 10 ppm or less, more preferably 1 ppm or less.

The material of the filter used in the above-described filtration step may be an organic material, such as cellulose and PTFE resin, or an inorganic material, such as metal typically exemplified by stainless steel-based material, glass fiber, quartz, diatomaceous earth, and ceramics. Not only liquid filters but also gas filters may be used. The standard of the filter is preferably in the range of 1 µm to 0.0001 µm for the precision of filtration.

The above-described filters may be used solely or in combination of two or more kinds of them. When filters are used in combination, for example, there may be used a method in which a filter of an organic material such as PTFE resin is used as a primary or lower-level filter and a filter of an inorganic material, such as quarts and metal, is used as a secondary or higher-level filter; a method in which a filter with low precision is used as the lower-level filter and a filter with high precision is used as the higher-level filter; or a combination of these methods. In particular, a SUS-based metallic gas filter outgases less and moisture in the filter can be easily removed, and therefore, by using this filter as the higher-level filter, the material for CVD of the present invention can be produced without lowering productivity. The filtration conditions, such as the flow rate of the material for CVD through the filter and the pressure, may be selected as appropriate to the material for CVD without any particular limitation.

The method for forming metal-containing thin films of the present invention is a method based on a CVD process, wherein a material for CVD of the present invention is used, a vapor obtained by vaporizing the material and a reactive gas used as required are introduced onto a substrate, and the precursor is subjected to decomposition and/or reaction on the substrate to grow and deposit a thin film on the substrate. There are no particular limitations on material delivery method, deposition mode, conditions on forming, formation instrument, or the like. Generally known conditions and methods or the like may be used.

The above-mentioned reactive gas used as necessary includes, for example, oxidizing gases such as oxygen, ozone, nitrogen dioxide, nitrogen monoxide, steam, hydrogen peroxide, formic acid, acetic acid, and acetic anhydride; reducing gases such as hydrogen; and gases for producing nitrides such as organic amines including monoalkylamines, dialkylamines, trialkylamines and alkylenediamines, hydrazine, and ammonia.

The above-mentioned material delivery method includes the vapor delivery system, the liquid delivery system, the multi-source system, and the single-source system described above.

The above-mentioned deposition mode includes thermal CVD in which only heat is used to cause a reaction of the vaporized material or a mixture of the vaporized material and a reactive gas to deposit a thin film, plasma-enhanced CVD in which heat and plasma are used, the photo-assisted CVD in which heat and light are used, photo plasma-assisted CVD in which heat, light, and plasma are used, and ALD (Atomic Layer Deposition) in which the deposition reaction in the CVD process is separated into elementary steps and deposition is performed stepwise at a molecular level.

The above-mentioned conditions of formation include the reaction temperature (the temperature of the substrate), the reaction pressure, the deposition rate, and the like. The reaction temperature is preferably 150°C or more, at which the metal compounds relating to the present invention reacts sufficiently, more preferably 200°C to 800°C. The reaction pressure is preferably an atmospheric pressure to 10 Pa for thermal CVD or photo-assisted CVD, while it is preferably 10 to 2000 Pa when plasma is used. The deposition rate can be controlled by the material feed conditions (vaporizing temperature, vaporizing pressure), the reaction temperature, and the reaction pressure. When the deposition rate is too high, the characteristics of the resultant thin film may be deteriorated, while too low deposition rate may result in poor productivity. Accordingly, the deposition rate is preferably 0.5 to 5000 nm/min, more preferably 1 to 1000 nm/min. In the case of ALD, the film thickness is controlled by the number of cycles to reach a desired film thickness.

In the method for forming metal-containing thin films of the present invention, after deposition, the thin film may be annealed under an inert, oxidizing, or reducing atmosphere to improve electrical characteristics. If step coverage is required, a step of reflowing the thin film may be provided. The temperature in reflowing is preferably 400°C to 1200°C, more preferably 500°C to 800°C.

A thin film formed by the method for forming metal-containing thin films of the present invention using the material for CVD of the present invention can be provided in any kind of thin film including metal, alloy, oxide ceramic, nitride ceramic, and carbide ceramic as desired. The application of the thin film includes a member of electronic components, such as a high dielectric constant capacitor film, a gated insulator film, a gated film, a ferroelectric capacitor film, a condenser film, and a barrier film; a member of optical glasses, such as optical fibers, optical waveguides, light amplifiers, and optical switches; and the like.

### Examples

Hereinafter, the present invention will be described in more detail with reference to Examples, Comparative Examples, and Evaluation Examples, but the present invention is not construed as being limited thereto.

### [Example 1] Production of material for CVD No. 1

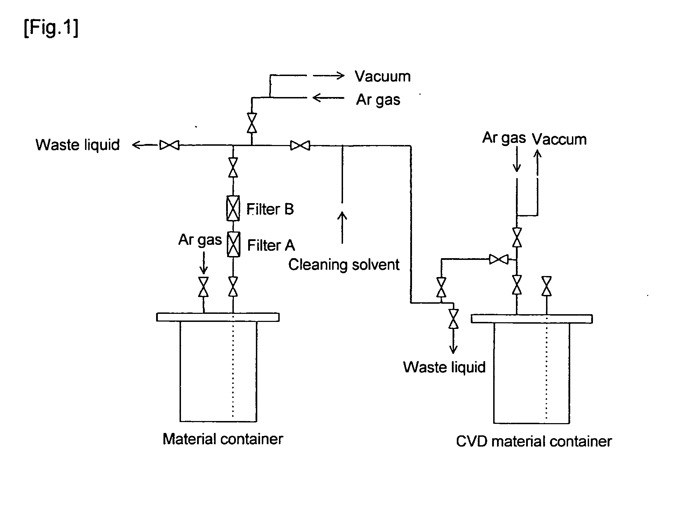

Material for CVD No. 1 was obtained by applying the particle removal step to a precursor composed of compound No. 8 under the following conditions using the apparatus shown in Fig. 1.
(Conditions)
Filter A: Housing; PFA, Filter; PTFE, Effective filtration area: 0.07 cm², Rated filtration precision (liquid); 0.1 µm
Filter B: not used
Filtration speed: 10 ml/min

### [Example 2] Production of material for CVD No. 2

Material for CVD No. 2 was obtained by applying the particle removal step to a precursor composed of compound No. 8 under the following conditions using the apparatus shown in Fig. 1.
(Conditions)
Filter A: Housing; PFA, Filter; PTFE, Effective filtration area: 0.07 m², Rated filtration precision (liquid); 0.1 µm
Filter B: Housing; SUS-316L, Filter; SUS-316L, Effective filtration area; 3.14 cm², Rated filtration precision (gas); 0.003 µm
Filtration speed: 10 ml/min

### [Example 3] Production of material for CVD No. 3

Material for CVD No. 3 was obtained by applying the particle removal step to a precursor composed of compound No. 51 under the following conditions using the apparatus shown in Fig. 1.
(Conditions)
Filter A: not used
Filter B: Housing; SUS-316L, Filter; SUS-316L, Effective filtration area; 43.8 cm², Rated filtration precision (gas); 0.003 µm
Filtration speed: 10 ml/min

### [Example 4] Production of material for CVD No. 4

Material for CVD No. 4 was obtained by applying the particle removal step to a precursor composed of compound No. 51 under the following conditions using the apparatus shown in Fig. 1.
(Conditions)
Filter A: Housing; PFA, Filter; PTFE, Effective filtration area: 0.07 m², Rated filtration precision (liquid); 0.1 µm
Filter B: Housing; SUS-316L, Filter; SUS-316L, Effective filtration area; 7.54 cm², Rated filtration precision; 0.003 µm
Filtration speed: 10 ml/min

### [Example 5] Production of material for CVD No. 5

Material for CVD No. 5 was obtained by applying the particle removal step to a precursor composed of compound No. 5 under the following conditions using the apparatus shown in Fig. 1.
(Conditions)
Filter A: Housing; PFA, Filter; PTFE, Effective filtration area: 0.07 m², Rated filtration precision (liquid); 0.1 µm
Filter B: Housing; SUS-316L, Filter; SUS-316L, Effective filtration area; 3.14 cm², Rated filtration precision (gas); 0.003 µm
Filtration speed: 10 ml/min

### [Example 6] Production of material for CVD No. 6

Material for CVD No. 6 was obtained by applying the particle removal step to a precursor composed of compound No. 89 under the following conditions using the apparatus shown in Fig. 1.
(Conditions)
Filter A: Housing; PFA, Filter; PTFE, Effective filtration area: 0.07 m², Rated filtration precision (liquid); 0.1 µm
Filter B: Housing; SUS-316L, Filter; SUS-316L, Effective filtration area; 3.14 cm², Rated filtration precision (gas); 0.003 µm
Filtration speed: 10 ml/min

### [Example 7] Production of material for CVD No. 7

Material for CVD No. 8 was obtained by applying the particle removal step to a precursor composed of compound No. 110 under the following conditions using the apparatus shown in Fig. 1.
(Conditions)
Filter A: Housing; PFA, Filter; PTFE, Effective filtration area: 0.07 m², Rated filtration precision (liquid); 0.1 µm
Filter B: Housing; SUS-316L, Filter; SUS-316L, Effective filtration area; 43.8 cm², Rated filtration precision (gas); 0.003 µm
Filtration speed: 10 ml/min

### [Example 8] Production of material for CVD No. 8

Material for CVD No. 8 was obtained by applying the particle removal step to a precursor composed of trimethylaluminum under the following conditions using the apparatus shown in Fig. 1.
(Conditions)
Filter A: Housing; SUS-316L, Filter; SUS-316L, Effective filtration area: 43.8 cm², Rated filtration precision (gas); 0.05 µm
Filtration speed: 10 ml/min
Filter B: Housing; SUS-316L, Filter; SUS-316L, Effective filtration area; 3.14 cm², Rated filtration precision (gas); 0.003 µm
Filtration speed: 10 ml/min

### [Example 9] Production of material for CVD No. 9

Material for CVD No. 9 was obtained by applying the particle removal step to a precursor composed of an octane solution source (octane content: 75% by mass) containing 1 part by mole of bis(2,2,6,6-tetramethylheptane-3,5-dionato)lead, 0.5 part by mole of compound No. 3, and 0.5 part by mole of compound No. 5 under the following conditions using the apparatus shown in Fig. 1.
(Conditions)
Filter A: Housing; PFA, Filter; PTFE, Effective filtration area: 0.07 m², Rated filtration precision (liquid); 0.1 µm
Filter B: Housing; SUS-316L, Filter; SUS-316L, Effective filtration area; 7.54 cm², Rated filtration precision (gas); 0.003 µm
Filtration speed: 10 ml/min

### [Evaluation Examples] Particle measurement

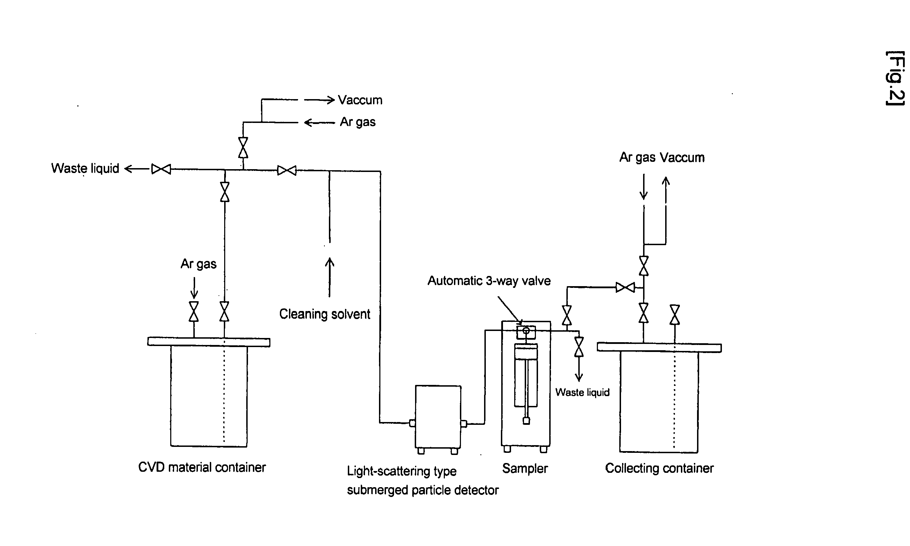

Particle counting was performed with the materials for CVD obtained in Examples 1 to 9 and the materials for CVD obtained in Comparative Examples 1 and 2, under the conditions 1 and 2 shown below, using the light scattering type submerged particle measurement system shown in Fig. 2. The results are shown in Table 1.
(Conditions 1)
Particles to be detected: > 0.5 µm
Light scattering type submerged particle detector: KS-40B (manufactured by Rion Co., Ltd.) Maximum rated particle concentration: 1200 pcs/ml (Counting loss for particles of 0.5 µm: 5%)
Detection limit: 0.1 particle/ml
Measuring flow rate: 10 ml/min
(Conditions 2)
Particles to be detected: > 0.2 µm and > 0.3 µm
Light scattering type submerged particle detector: KS-28E (manufactured by Rion Co., Ltd.) Maximum rated particle concentration: 1200 pcs/ml (Counting loss for particles of minimum size to be detected: 5%)
Detection limit: 0.1 particle/ml
Measuring flow rate: 10 ml/min

**[Table 1]**

| Material for CVD | > 0.5 µm (pcs/ml) | > 0.3 µm (pcs/ml) | > 0.2 µm (pcs/ml) |
|---|---|---|---|
| Example 1: material for CVD No. 1 | less than detection limit | 3.9 | 506 |
| Example 2: material for CVD No. 2 | less than detection limit | 3.0 | 6.2 |
| Example 3: material for CVD No. 3 | 40.8 | > 1200 | > 1200 |
| Example 4: material for CVD No. 4 | less than detection limit | 8.6 | 41.8 |
| Example 5: material for CVD No. 5 | less than detection limit | 4.8 | 8.2 |
| Example 6: material for CVD No. 6 | less than detection limit | 3.6 | 7.5 |
| Example 7: material for CVD No. 7 | less than detection limit | 4.0 | 7.7 |
| Example 8: material for CVD No. 8 | less than detection limit | 5.3 | 18.8 |
| Example 9: material for CVD No. 9 | less than detection limit | 1.2 | 2.9 |
| Comparative Example 1: Compound No. 8 | 172 | > 1200 | > 1200 |
| Comparative Example 2: Compound No. 51 | 817 | > 1200 | > 1200 |

| | | | |
|---|---|---|---|
| Comparative Examples represent the results for the metal compounds before passing through the filters. | | | |

### [Example 10] Formation of a thin film of hafnium oxide

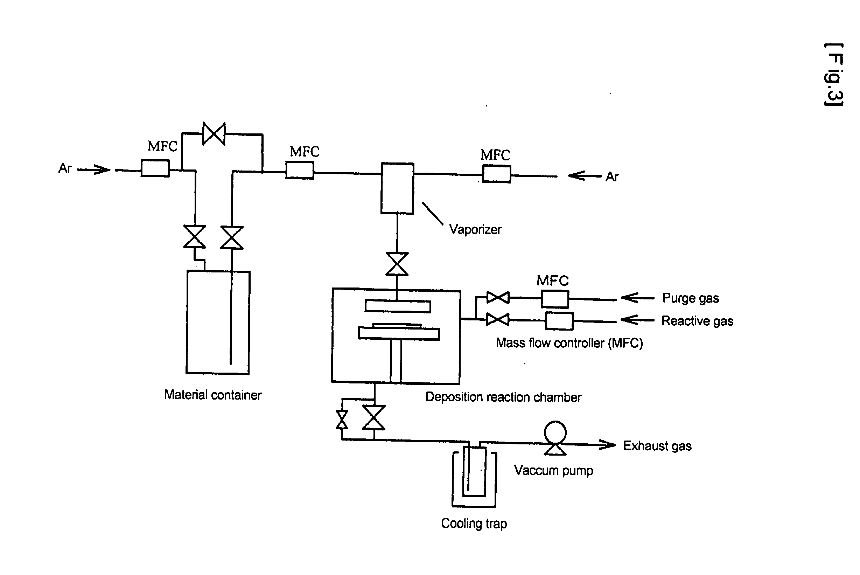

A thin film of hafnium oxide was formed using material for CVD No. 3 obtained in Example 3 with the CVD instrument shown in Fig. 3 under the following conditions by the following steps. The number of particles of 0.1 µm to 0.3 µm in the resultant thin film was determined with a dark field wafer inspection system. The result is shown below.
(Conditions)
Reaction temperature (substrate temperature); 200°C, Reactive gas; O₂/O₃ (mole) = 1/1
(Steps)
A series of steps consisting of the following (1) to (4) was used as one cycle, 80 cycles were repeated, and finally annealing was performed at 500°C for 3 min.
(1) The material for CVD was vaporized in a vaporizer at a temperature of 150°C under a pressure of 2000 to 2200 Pa, the vapor was introduced into the system, and the material was deposited under a system pressure of 2000 to 2200 Pa for 2 sec.
(2) Through argon purge for 3 sec, unreacted source material was removed.
(3) The reactive gas was introduced to perform reaction under a system pressure of 1300 Pa for 2 sec.
(4) Through argon purge for 2 sec, unreacted source material was removed.
(Result)
Number of particles: 1.16 particles/square inch

### [Example 11] Formation of a thin film of hafnium oxide

A thin film of hafnium oxide was formed and the number of particle in the resultant film was determined by the same method as that of Example 10, except for using material for CVD No. 4 obtained in Example 4.
(Results)
Number of particles: 0.11 particles/square inch

### [Comparative Example 3] Formation of hafnium oxide thin film

A thin film of hafnium oxide was formed and the number of particle in the resultant film was determined by the same method as that of Example 10, except for using the CVD material of Comparative Example 2 described in Table 1 as the material for CVD.
(Results)
Number of particles: 14.4 particles/square inch

### Industrial Applicability

The present invention provides a material for CVD having reduced number of particles and thin films wherein contamination by particle is suppressed by using this material for CVD. The present invention can also provide a thin film forming method using this material for CVD.

## Claims

1. A material for chemical vapor deposition comprising a precursor composed of a metal compound, wherein the material contains 100 or less particles having a size of 0.5 µm or more in 1 ml, in particle measurement by a light scattering type submerged particle detector in a liquid phase.

2. The material for chemical vapor deposition according to claim 1, wherein the number of particles having a size of 0.3 µm or more is 100 or less in 1 ml, in particle measurement by a light scattering type submerged particle detector.

3. The material for chemical vapor deposition according to claim 1 or 2, wherein the number of particles having a size of 0.2 µm or more is 1000 or less in 1 ml, in particle measurement by a light scattering type submerged particle detector.

4. The material for chemical vapor deposition according to claim 3, wherein the number of particles having a size of 0.2 µm or more is 100 or less in 1 ml, in particle measurement by a light scattering type submerged particle detector.

5. The material for chemical vapor deposition according to any one of claims 1 to 4, wherein the precursor is composed of a metal compound having a structure wherein the group represented by general formula (I) shown below bonds to the metal atom: 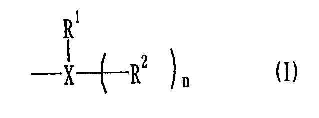 wherein X represents an oxygen atom or a nitrogen atom; n represents 0 when X is an oxygen atom or n represents 1 when X is a nitrogen atom; R¹ represents an organic group having 1 to 10 carbon atoms; and R² represents a hydrogen atom or an organic group having 1 to 10 carbon atoms.

6. The material for chemical vapor deposition according to any one of claims 1 to 4, wherein the precursor is composed of a metal compound having a structure wherein the group represented by general formula (II) shown below bonds to the metal atom:
-R³ (II)
wherein R³ represents an alkyl group having 1 to 8 carbon atoms or a cyclopentadienyl group having 1 to 10 carbon atoms.

7. The material for chemical vapor deposition according to any one of claims 1 to 6, wherein the metal compound is selected from an aluminum compound, a titanium compound, a zirconium compound, a hafnium compound, a tantalum compound, and a niobium compound.

8. The material for chemical vapor deposition according to claim 7, wherein the metal compound is a hafnium compound.

9. The material for chemical vapor deposition according to any one of claims 1 to 8, which is delivered or fed in a liquid phase.

10. A method for forming metal-containing thin films by chemical vapor deposition process using the material for chemical vapor deposition according to any one of claims 1 to 9.
